(19) Europäisches Patentamt
European Patent Office
Office européen des brevets

(11) **EP 4 582 823 A1**

(12) **EUROPEAN PATENT APPLICATION**
published in accordance with Art. 153(4) EPC

(43) Date of publication:
**09.07.2025 Bulletin 2025/28**

(21) Application number: 23859803.1

(22) Date of filing: **22.06.2023**

(51) International Patent Classification (IPC):
*G01R 31/392* (2019.01)    *G01R 31/382* (2019.01)
*G01R 31/385* (2019.01)    *G01R 31/389* (2019.01)
*H01M 10/48* (2006.01)    *H02J 7/00* (2006.01)

(52) Cooperative Patent Classification (CPC):
**G01R 31/382; G01R 31/385; G01R 31/389;**
**G01R 31/392; H01M 10/48; H02J 7/00;** Y02E 60/10

(86) International application number:
**PCT/JP2023/023085**

(87) International publication number:
**WO 2024/048033 (07.03.2024 Gazette 2024/10)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **29.08.2022 JP 2022135627**

(71) Applicant: **HITACHI HIGH-TECH CORPORATION**
**Tokyo 105-6409 (JP)**

(72) Inventors:
• **YONEMOTO, Masahiro**
**Tokyo 100-8280 (JP)**
• **INOUE, Takeshi**
**Tokyo 100-8280 (JP)**

• **HONKURA, Kohei**
**Tokyo 100-8280 (JP)**
• **HIRASAWA, Shigeki**
**Tokyo 105-6409 (JP)**
• **KONISHI, Hiroaki**
**Tokyo 105-6409 (JP)**
• **MOCHIZUKI, Masahito**
**Tokyo 105-6409 (JP)**
• **SUMIKAWA, Yosuke**
**Tokyo 105-6409 (JP)**
• **HORIKOSHI, Nobuya**
**Tokyo 105-6409 (JP)**

(74) Representative: **Mewburn Ellis LLP**
**Aurora Building**
**Counterslip**
**Bristol BS1 6BX (GB)**

(54) **CAPACITY DETERIORATION ESTIMATION DEVICE**

(57)    An object is to appropriately estimate capacity deterioration of a storage battery. To this end, a capacity deterioration estimation device (110) includes a data receiver (112) configured to receive measurement results of a current value (I) and a voltage value (V) of a storage battery (101) from a measuring part (102) configured to measure the current value (I) and the voltage value (V); and a first capacity deterioration estimator (114), and the first capacity deterioration estimator (114) has a function of reading first to fourth tables (MP1 to MP4) from a table storage (116) and a function of calculating a first estimated capacity deterioration rate ($SOHQ_A$) based on first to fourth relational expressions at start of charging.

**FIG. 2**

## Description

### TECHNICAL FIELD

The present invention relates to a capacity deterioration estimation device.

### BACKGROUND ART

It is preferable to estimate capacity deterioration of a storage battery to appropriately determine a replacement timing of a storage battery system in a device or equipment using the storage battery such as, for example, an electric vehicle. Patent Literatures 1 and 2 listed below describe techniques of estimating the capacity deterioration of the storage battery. Description of these literatures are included as part of the present application.

### CITATION LIST

### Patent Literature

Patent Literature 1: JP2019-021417A
Patent Literature 2: JP2020-187050A

### SUMMARY OF INVENTION

### Technical Problem

There is a demand for more appropriately estimating the capacity deterioration of the storage battery in the above-mentioned techniques.
The present invention has been made in view of the above-mentioned situation, and an object is to provide a capacity deterioration estimation device that can appropriately estimate the capacity deterioration of the storage battery.

### Solution to Problem

A capacity deterioration estimation device of the present invention for solving the above-mentioned problem includes: a data receiver configured to receive measurement results of a current value and a voltage value of a storage battery from a measuring part configured to measure the current value, the voltage value, and a temperature of the storage battery; and a first capacity deterioration estimator, and the first capacity deterioration estimator has a function of reading, from a table storage, a first table storing a relationship between a resistance deterioration rate of the storage battery and an estimated capacity deterioration rate being an estimated value of a capacity deterioration rate, a second table storing a relationship between a state of charge of the storage battery and a reference resistance value being a resistance value of the storage battery in an undeteriorated state at a predetermined temperature, a third table storing a relationship between the temperature of the storage battery and a temperature conversion coefficient being a ratio with respect to the reference resistance value, and a fourth table storing a relationship between the state of charge and a terminal open voltage of the storage battery, and a function of calculating a first estimated capacity deterioration rate based on a first relational expression defining relationships among the reference resistance value, the resistance deterioration rate, and a start-of-charging state of charge being the state of charge at start of charging, a second relational expression defining relationships among the reference resistance value, the resistance deterioration rate, and an end-of-charging state of charge being the state of charge at end of charging, a third relational expression defining relationships among the start-of-charging state of charge, the end-of-charging state of charge, the first estimated capacity deterioration rate, and a charged electric amount being an electric amount from the start of charging to the end of charging, and a fourth relational expression defining a relationship between the resistance deterioration rate and the first estimated capacity deterioration rate.

### Advantageous Effects of Invention

According to the present invention, the capacity deterioration of the storage battery can be appropriately estimated.

**BRIEF DESCRIPTION OF DRAWINGS**

Fig. 1 is a block diagram of a computer.
Fig. 2 is a block diagram of a capacity deterioration rate estimation system according to a first embodiment.
Fig. 3 is a diagram showing an example of a characteristic stored in a map MP1.
Fig. 4 is a diagram showing an example of a characteristic stored in a map MP2.
Fig. 5 is a diagram showing an example of a characteristic stored in a map MP3.
Fig. 6 is a diagram showing an example of a characteristic stored in a map MP4.
Fig. 7 is a diagram showing an example of a control flowchart according to the first embodiment.
Fig. 8 is a block diagram of a capacity deterioration rate estimation system according to a second embodiment.
Fig. 9 is a diagram showing an example of a SOC-charging overvoltage characteristic of a storage battery using a lithium iron phosphate positive electrode in an undeteriorated state.

**DESCRIPTION OF EMBODIMENTS**

[Outline of Embodiments]

For example, the following methods #1 to #3 are conceivable as a method of estimating a capacity of a storage battery.

·Method #1: The capacity of the storage battery is estimated based on a current integrated value in the case where the storage battery is regularly charged to a full-charge voltage and then discharged from this voltage to a discharge lower limit voltage.
·Method #2: Open circuit voltages (OCV) before and after a charging or discharging are first estimated, and then estimated values (SOCv) of a state of charge before and after the charging or discharging are calculated based on a relationship between the open circuit voltage (OCV) and the SOC. Then, the capacity of the storage battery is estimated based on a difference ($\Delta$SOCv) between the estimated values before and after the charging or discharging and a ratio of charged charge amount.
·Method #3: A fact that a resistance deterioration rate and a capacity deterioration rate of the storage battery are correlated to each other to some extent is utilized to estimate the capacity deterioration rate based on the resistance deterioration rate that is relatively easy to measure.

The above-mentioned Patent Literature 1 is categorized into the method #2, and Patent Literature 2 is categorized into the method #3. The method #1 is sometimes used as a true value of the storage battery capacity. However, in an actual system such as an electric vehicle, the storage battery is rarely discharged from the full-charge voltage to the discharge lower limit voltage at which the electric vehicle cannot move due to running-out of the battery. Accordingly, in many cases, it is difficult to frequently perform measurement corresponding to the method #1. Meanwhile, in the method #2, since there is no need to discharge the storage battery to the discharge lower limit voltage, a measurement timing can be more easily secured. Moreover, since the resistance deterioration rate of the storage battery is relatively easy to measure, the measurement timing can be easily secured also in the method #3. However, since the resistance deterioration rate and the capacity deterioration rate are affected by a difference in a load pattern, a difference in a manufacturing step of the storage battery, and the like, the resistance deterioration rate and the capacity deterioration rate do not necessarily have a relationship in which one is uniquely identified by the other. Accordingly, estimation accuracy of the method #3 basically tends to decrease with progress of deterioration.
Moreover, in common to the methods #2 and #3 described above, in many cases, these methods are difficult to apply to, for example, a storage battery in which a lithium iron phosphate positive electrode and a graphite negative electrode are combined. This is because, in this type of storage battery, a change of open circuit voltage (OCV) is small with respect to the SOC in almost the entire SOC range. In further detail, first in the method #2, even when an estimation error of the open circuit voltage is small, an estimation error of the SOCv is large. Accordingly, the SOCs before and after the charging or discharging both need to within a SOC range in which the OCV change is large.
Accordingly, in the method #2, there a problem that timings at which sufficient accuracy can be obtained are few. Meanwhile, in the method #3, a reference resistance in the calculation of the resistance deterioration rate has temperature dependency and SOC dependency. Accordingly, when the SOC cannot be correctly estimated, shifting of the reference resistance is reflected as an error of the estimated value of the capacity. The embodiments to be described below achieve highly-accurate, high-frequency estimation of the capacity deterioration rate for a storage battery in which the change of the open circuit voltage (OCV) with respect to the SOC is small in almost the entire SOC range.

[First Embodiment]

(Configuration of First Embodiment)

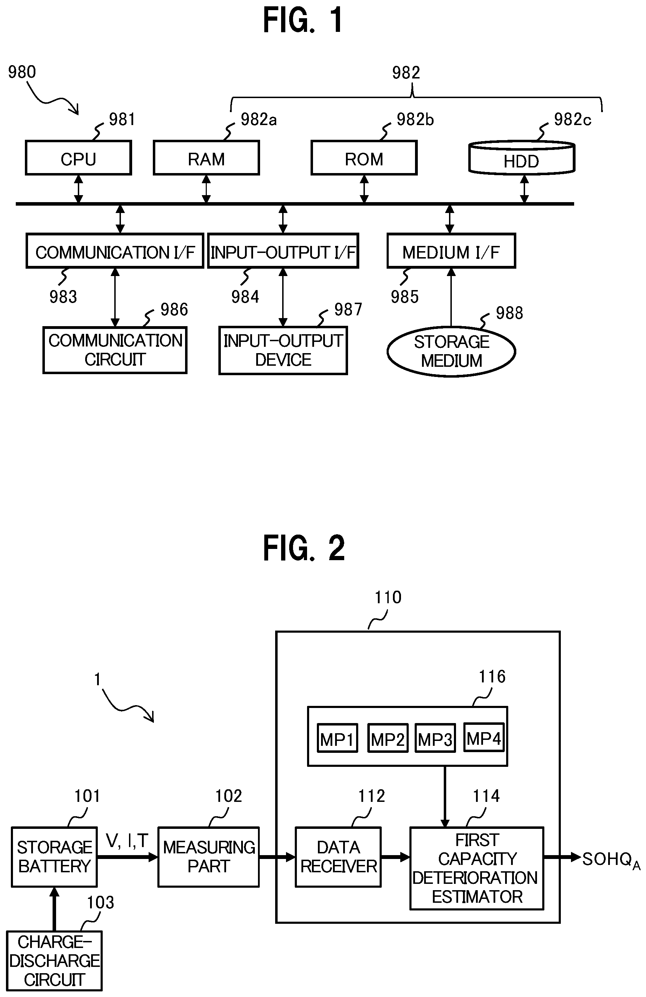

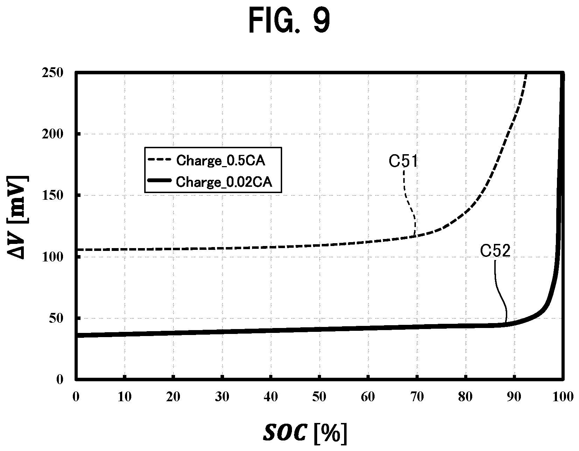

Fig. 1 is a block diagram of a computer 980 used in common in a first embodiment to a fourth embodiment. A capacity deterioration estimation device 110 (see Fig. 2) and a capacity deterioration estimation device 150 (see Fig. 9) to be described later each include one or multiple computers 980 shown in Fig. 1.

In Fig. 1, the computer 980 includes a CPU 981, a storage 982, a communication I/F (interface) 983, an input-output I/F 984, and a medium I/F 985. In this example, the storage 982 includes a RAM 982a, a ROM 982b, and an HDD 982c. The communication I/F 983 is connected to a communication circuit 986. The input-output I/F 984 is connected to an input-output device 987. The medium I/F 985 reads and writes data from and to a storage medium 988.

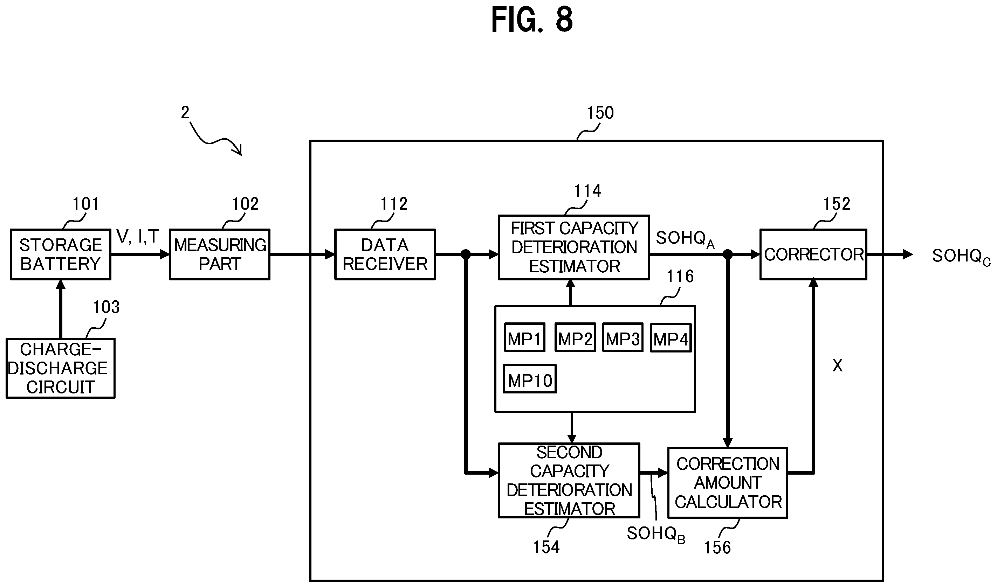

An IPL (internal program loader) and the like executed by the CPU are stored in the ROM 982b. A control program, various pieces of data, and the like are stored in the HDD 982c. The CPU 981 executes the control program and the like read from the HDD 982c and loaded onto the RAM 982a to implement various functions. In an inside of each of the capacity deterioration estimation device 110 (see Fig. 2) and the capacity deterioration estimation device 150 (see Fig. 8) to be described later, the functions to be implemented by the control program and the like are shown as blocks.

Fig. 2 is a block diagram of a capacity deterioration rate estimation system 1 according to the first embodiment.

In Fig. 2, the capacity deterioration rate estimation system 1 includes a storage battery 101, a measuring part 102, a charge-discharge circuit 103, and the capacity deterioration estimation device 110 (computer). Moreover, the capacity deterioration estimation device 110 includes a data receiver 112 (data receiving means), a first capacity deterioration estimator 114 (first capacity deterioration estimating means), and a map storage 116 (table storage). The first capacity deterioration estimator 114 is a device that estimates capacity deterioration by utilizing a correlation between resistance deterioration and the capacity deterioration, and details thereof are described later.

A lithium-ion battery, a lead storage battery, a nickel-hydrogen battery, a nickel-cadmium battery, and the like can be given as the storage battery 101, but the storage battery 101 is not limited to these. The measuring part 102 measures a current value I in charging and discharging of the storage battery 101, a voltage value V being a terminal voltage, and a battery temperature T. The charge-discharge circuit 103 charges and discharges the storage battery 101 based on control by the capacity deterioration estimation device 110. The data receiver 112 receives a measurement results of the measuring part 102. The first capacity deterioration estimator 114 outputs an estimated capacity deterioration rate $SOHQ_A$ (first estimated capacity deterioration rate) that is an estimated value of a capacity deterioration rate $SOHQ$ of the storage battery 101, based on the measurement results received by the data receiver 112.

The map storage 116 stores maps MP1, MP2, MP3, and MP4 (first, second, third, and fourth tables). In this example, a relationship between a resistance deterioration rate $SOHR$ and an estimated capacity deterioration rate $SOHQ_{map}$ (SOHR) that is an estimated value of a capacity deterioration rate $SOHQ$ corresponding to the resistance deterioration rate $SOHR$ is stored in advance in the map MP1.

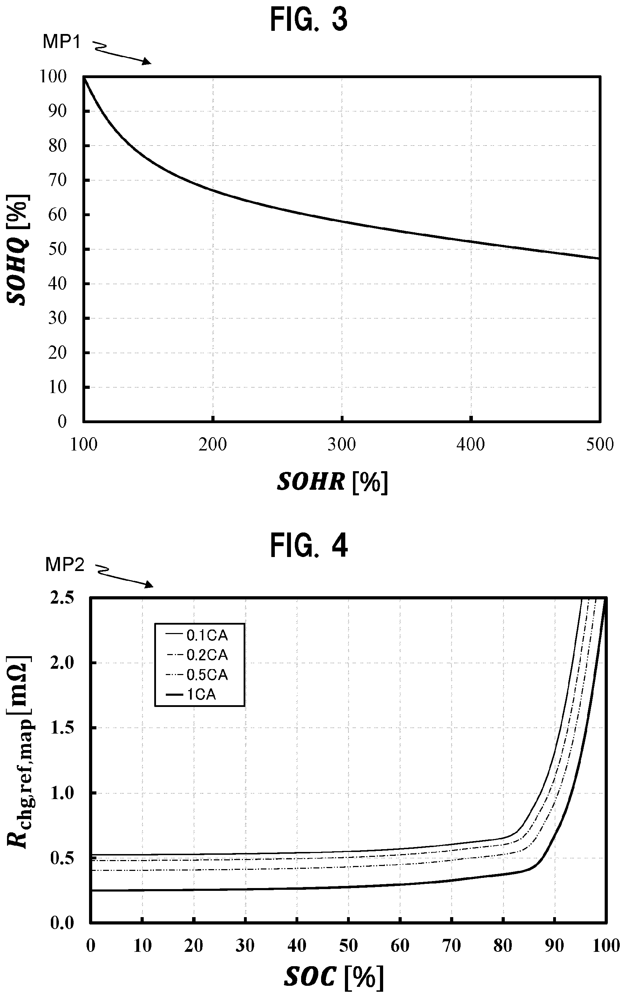

Fig. 3 is a diagram showing an example of a characteristic stored in the map MP1.

In Fig. 3, the horizontal axis represents the resistance deterioration rate $SOHR$, and the vertical axis represents the capacity deterioration rate $SOHQ$. As shown in Fig. 3, the estimated value of the capacity deterioration rate $SOHQ$, that is the estimated capacity deterioration rate $SOHQ_{map}$ (SOHR) can be obtained by using the map MP1 and setting the resistance deterioration rate $SOHR$ as an argument.

Moreover, the map MP2 stores relationships among a reference resistance value $R_{chg,ref,map}$, the SOC, and a charge rate $C_{rate}$. Specifically, the reference resistance value $R_{chg,ref,map}$ is a function of the SOC and the charge rate $C_{rate}$, and is expressed as "$R_{chg,ref,map}$ (SOC, $C_{rate}$)" in some cases.

In the example, the reference resistance value $R_{chg,ref,map}$ (SOC, $C_{rate}$) is an internal resistance value of the storage battery 101 at a reference temperature in the case where the storage battery 101 is in an unused state or in a state close to the unused state (hereinafter, referred to as undeteriorated state). Moreover, the charge rate $C_{rate}$ is a value obtained by dividing the current value I by an initial rated capacity $Q_{max,ini}$ (rated capacity of the storage battery 101 in the undeteriorated state). In this case, a temperature condition at the reference resistance value $R_{chg,ref,map}$ is referred to as the reference temperature. Although the reference temperature is not limited to a particular temperature, the reference temperature is 25°C in the present embodiment. Moreover, the reference resistance value $R_{chg,ref,map}$ is a resistance value x seconds after start of charging. In this case, the value of x can be determined to be any value.

Fig. 4 is a diagram showing an example of a characteristic stored in the map MP2.

In Fig. 4, the horizontal axis represents the SOC, and the vertical axis represents the reference resistance value $R_{chg,ref,map}$. As shown in Fig. 4, the reference resistance value $R_{chg,ref,map}$ can be obtained by using the map MP2 and setting the SOC and the charge rate $C_{rate}$ as arguments. The charge rate $C_{rate}$ is included in the arguments in the map MP2, because there is a case where the resistance value cannot necessarily be considered as constant as in Butler-Volmer equation. There is also a case where the resistance value can be considered as constant even when the charge rate $C_{rate}$ changes, depending on the battery. In this case, the argument may include only the SOC.

Moreover, the map MP3 is a map for storing a relationship between a temperature conversion coefficient $K_{T,map}$ (T) and the battery temperature T (unit; °C) in advance. The temperature conversion coefficient $K_{T,map}$ (T) is a coefficient that expresses a ratio of the internal resistance value at the battery temperature T to the internal resistance value at the reference temperature of the storage battery 101.

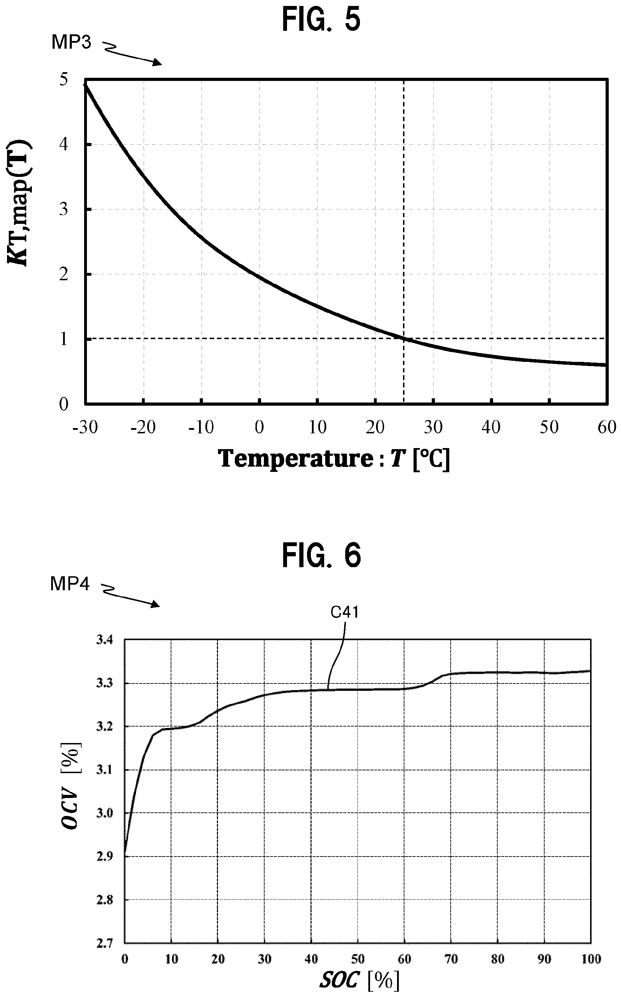

Fig. 5 is a diagram showing an example of a characteristic stored in the map MP3.

In Fig. 5, the horizontal axis represents the battery temperature T (unit; °C), and the vertical axis represents the temperature conversion coefficient $K_{T,map}$ (T) in the case where the coefficient at the reference temperature (25°C in Fig. 5) is "1". As shown in Fig. 5, the temperature conversion coefficient $K_{T,map}$ (T) can be also obtained by using the map MP1 and setting the battery temperature T (unit; °C) as an argument.

Moreover, the map MP4 is a map for storing a relationship between the state of charge SOC of the battery and the open circuit voltage OCV in advance.

Fig. 6 is a diagram that shows an example of an SOC-OCV characteristic of the storage battery using the lithium iron phosphate positive electrode, as a diagram showing an example of a characteristic stored in the map MP4. Note that, although this storage battery is a storage battery preferably applied to the storage battery 101 in the present embodiment, the storage battery 101 is not limited to the storage battery type described above.

In Fig. 6, the horizontal axis represents the SOC, and the vertical axis represents the open circuit voltage OCV.

According to a SOC-OCV characteristic C41 of the storage battery, a change amount of the OCV with respect to a change of the SOC is large in a region where the SOC is 6% or less. Accordingly, particularly in the case where the OCV immediately before the start of charging is low, the SOC at the start of charging can be accurately obtained based on the OCV. However, in the case where the SOC reaches almost 100% at the end of charging, the change amount of the OCV is small with respect the change of the SOC. Accordingly, in the case where the SOC is almost 100%, it is difficult to accurately estimate the SOC from the OCV. Thus, in order to estimate the SOC at the end of charging, it is preferable to use a charging overvoltage characteristic or a resistance characteristic instead of the SOC-OCV characteristic.

Returning to Fig. 1, the first capacity deterioration estimator 114 calculates the estimated capacity deterioration rate $SOHQ_A$ based on [Math 1], [Math 2], [Math 3], and [Math 4] to be described later.

[Math 1]

$$SOHR = \frac{\dfrac{CCV_{start} - OCV_{map}(SOC_{start})}{C_{rate,start} \times Q_{rated}}}{R_{chg,ref,map}(SOC_{start}, C_{rate,start}) \times K_{T,map}(T_{start})} \quad \cdots (1)$$

[Math 1] is a mathematical expression for obtaining the resistance deterioration rate SOHR at the start of charging by using the current, voltage, and temperature at the start of charging and the maps MP2, MP3, and MP4 stored in the map storage 116.

In [Math 1], a numerator on the right-hand side calculates an actual resistance value, and a denominator on the right-hand side calculates a reference resistance value in an undeteriorated battery.

$CCV_{start}$ is a CCV (closed circuit voltage) at the start of charging, that is the voltage value V in the case where a load (illustration omitted) is connected between a positive electrode terminal and a negative electrode terminal (illustration omitted) of the storage battery 101. $OCV_{map}$ is a map value determining the OCV depending on the SOC, and a start-of-charging state of charge $SOC_{start}$ is the state of charge of the storage battery 101 at the start of charging. Note that the start-of-charging state of charge $SOC_{start}$ is an unknown value at the start of charging.

Moreover, a start-of-charging charge rate $C_{rate,start}$ is the charge rate $C_{rate}$ at the start of charging. Furthermore, $Q_{rated}$ is a capacity (rated capacity or the like) to be a reference of SOHQ of battery=100%. Moreover, the reference resistance value $R_{chg,ref,map}$ (SOC, $C_{rate,start}$) is an internal resistance value R of the storage battery 101 in the undeteriorated state at the reference temperature, and is a value corresponding to the start-of-charging charge rate $C_{rate,start}$. A start-of-charging temperature $T_{start}$ is the battery temperature T at the start of charging. The temperature conversion coefficient $K_{T,map}$ ($T_{start}$) is a temperature conversion coefficient obtained by using the map MP3 described above.

[Math 2]

$$SOHR = \frac{\dfrac{CCV_{end} - OCV_{map}(SOC_{end})}{C_{rate,end} \times Q_{rated}}}{R_{chg,ref,map}(SOC_{end}, C_{rate,end}) \times K_{T,map}(T_{end})} \quad \cdots (2)$$

[Math 2] is a mathematical expression for obtaining the resistance deterioration rate SOHR at the end of charging by using the current, voltage, and temperature at the end of charging and the maps MP2, MP3, and MP4 stored in the map storage 116.

In [Math 2], a numerator on the right-hand side calculates an actual resistance value at the end of charging, and a denominator on the right-hand side calculates a reference resistance value at the end of charging in an undeteriorated battery. $CCV_{end}$, $SOC_{end}$, $C_{rate,end}$, and $T_{end}$ are the closed circuit voltage, the state of charge, the charge rate, and the battery temperature at the end of charging, respectively. Among these values, $SOC_{end}$ is an unknown variable.

[Math 3]

$$SOC_{end} = SOC_{start} + \frac{\int_{t_{start}}^{t_{end}} I \cdot dt}{Q_{max,rated} \times SOHQ_A} \quad \dots (3)$$

[Math 3] is a mathematical expression for obtaining an end-of-charging state of charge $SOC_{end}$ by using the start-of-charging state of charge $SOC_{start}$ and the estimated capacity deterioration rate $SOHQ_A$.

In the second term on the right-hand side of [Math 3], $t_{start}$ is a time point of the start of charging, and $t_{end}$ is a time point of the end of charging. An integrated result of the current between these two time points is referred to as a charged electricity amount. Moreover, $Q_{max,rated}$ is a capacity (rated capacity or the like) to be a reference of SOHQ of storage battery 101 in undeteriorated state=100%.

[Math 4]

$$SOHQ_A = SOHQ_{map}(SOHR) \quad \dots (4)$$

[Math 4] is a mathematical expression for obtaining the estimated capacity deterioration rate $SOHQ_A$ by using the resistance deterioration rate SOHR and the map MP1 stored in the map storage 116.

The first capacity deterioration estimator 114 (see Fig. 1) numerically solves the simultaneous equations of [Math 1] to [Math 4] to obtain $SOC_{start}$, $SOC_{end}$, SOHR, and SOHQ that are four unknown variables in [Math 1] to [Math 4]. The first capacity deterioration estimator 114 outputs a thereby-obtained estimated value of the capacity deterioration rate SOHQ as the estimated capacity deterioration rate $SOHQ_A$.

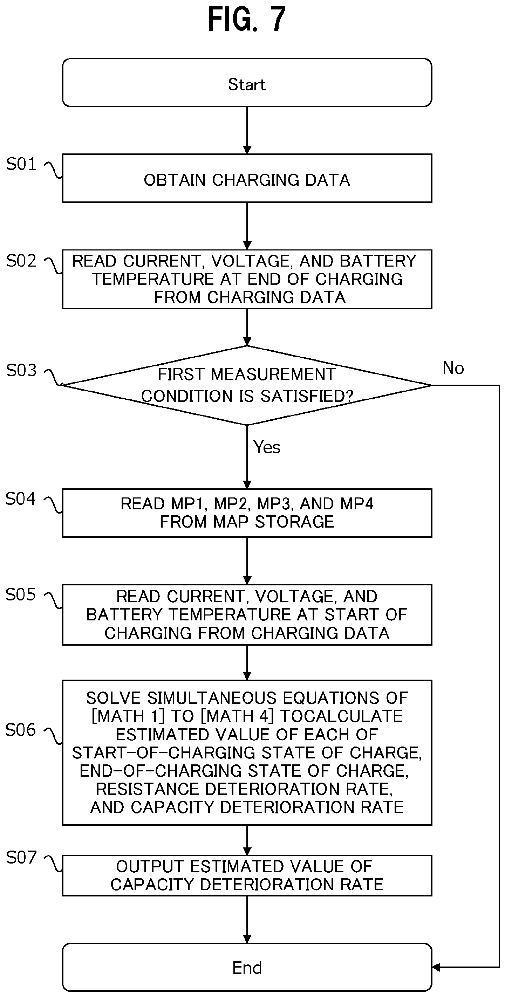

Fig. 7 is an example of a flowchart of a control program executed in the capacity deterioration estimation device 110 in the first embodiment.

In the case where the processing proceeds to step S01 in Fig. 7, the data receiver 112 obtains charging data from the measuring part 102. In this case, the charging data is time-series information of the current value I, the voltage value V, and the battery temperature T in charging and discharging.

Next, when the processing proceeds to step S02, the first capacity deterioration estimator 114 reads the current value I, the voltage value V, and the battery temperature T at the end of charging from the charging data. Then, when the processing proceeds to step S03, the first capacity deterioration estimator 114 determines whether a first measurement condition is satisfied or not based on the current value I, the voltage value V, and the battery temperature T at the end of charging. In this case, the first measurement condition is such a condition that the storage battery 101 is "charged to a point close to full charge", more specifically, such a condition that "the voltage of the storage battery 101 immediately before the charging completion is equal to or higher than a predetermined first threshold voltage".

When determination of "No" is made in step S03, the present routine is terminated. Meanwhile, when determination of "Yes" is made, the processing proceeds to step S04. In this step, the first capacity deterioration estimator 114 reads the maps MP1, MP2, MP3, and MP4 from the map storage 116. Next, when the processing proceeds to step S05, the first capacity deterioration estimator 114 reads the current value I, the voltage value V, and the battery temperature T at the start of charging from the charging data.

Then, when the processing proceeds to step S06, the first capacity deterioration estimator 114 numerically solves the simultaneous equations of [Math 1] to [Math 4] to be described later to calculate the estimated value of each of the start-of-charging state of charge $SOC_{start}$, the end-of-charging state of charge $SOC_{end}$, the resistance deterioration rate SOHR, and the capacity deterioration rate SOHQ. Specifically, in step S06, the first capacity deterioration estimator 114 calculates numerical solutions of the above-mentioned simultaneous equations by using the bisection method, the Newton's method, or the like. Next, when the processing proceeds to step S07, the first capacity deterioration estimator 114 outputs the estimated value of the capacity deterioration rate SOHQ as the estimated capacity deterioration rate $SOHQ_A$.

[Second Embodiment]

Next, a second embodiment is explained. The second embodiment is an embodiment in which a capacity deterioration estimation error caused by errors in the implemented various maps, errors in the charging data, and the like in the first embodiment is attempted to be reduced. To this end, when a predetermined second measurement condition is incidentally met, a highly-accurate capacity deterioration estimated value is used to perform offset correction of the next capacity deterioration estimated value and beyond.

In this case, the "second measurement condition" is such a condition that the storage battery 101 is "charged from a state where the SOC is almost 0% to a state close to full charge", more specifically, is such a condition that "the voltage immediately before the start of charging of the storage battery 101 is a predetermined second threshold voltage or lower and the voltage immediately before the completion of charging is the above-mentioned first threshold or higher".

Fig. 8 is a block diagram of a capacity deterioration rate estimation system 2 according to the second embodiment. Note that, in the following explanation, parts corresponding to the parts in the first embodiment described above are denoted by the same reference numerals, and explanation thereof is omitted in some cases.

In Fig. 8, the capacity deterioration rate estimation system 2 includes the storage battery 101, the measuring part 102, the charge-discharge circuit 103, and the capacity deterioration estimation device 150 (computer). Moreover, the capacity deterioration estimation device 150 includes the data receiver 112, the first capacity deterioration estimator 114, the map storage 116, a second capacity deterioration estimator 154, a correction amount calculator 156, and a corrector 152.

Configurations of the storage battery 101, the measuring part 102, the charge-discharge circuit 103, the data receiver 112, the first capacity deterioration estimator 114, and the map storage 116 among the elements described above are the same as those in the first embodiment (see Fig. 2). Note that a map MP10 to be described later is stored in the map storage 116. When the above-mentioned second measurement condition is met, the second capacity deterioration estimator 154 obtains an estimated capacity deterioration rate $SOHQ_B$ (second estimated capacity deterioration rate) that is the estimated value of the capacity deterioration rate SOHQ. A method of obtaining the estimated capacity deterioration rate $SOHQ_B$ is described below in detail.

Fig. 9 is a diagram showing an example of a SOC-charging overvoltage ($\Delta V$) characteristic of the storage battery using the lithium iron phosphate positive electrode in the undeteriorated state.

When the storage battery is being charged, the voltage value V of the storage battery is higher than the OCV due to a polarization phenomenon. A value obtained by subtracting the OCV from the voltage value V of the storage battery in charging is referred to as charging overvoltage $\Delta V$. A characteristic C51 of Fig. 9 is a characteristic of the charging overvoltage $\Delta V$ in the case where the charge rate is 0.5 [CA], and a characteristic C52 is a characteristic of the charging overvoltage $\Delta V$ in the case where the charge rate is 0.02 [CA]. Note that a "charge rate of 1 [CA]" means a current density at which the battery capacity is charged in one hour.

According to the characteristics C51 and C52, the charging overvoltage $\Delta V$ increases as the SOC approaches 100%. The SOC at the end of charging can be identified by using this characteristic. Specifically, the estimated capacity deterioration rate $SOHQ_B$ that is the estimated value of the capacity deterioration rate SOHQ can be obtained with high accuracy by obtaining the SOC immediately before the start of charging based on Fig. 6 and obtaining the SOC at the end of charging based on Fig. 9. Specifically, the estimated capacity deterioration rate $SOHQ_B$ can be obtained by numerically solving [Math 5] described below.

[Math 5]

$$SOHQ_B = \frac{\int_{t_{\text{start}}}^{t_{\text{end}}} I \cdot dt}{Q_{\text{max,ini}}} \times \frac{1}{SOC_{\text{end}} - SOC_{\text{start}}}$$

$$SOC_{\text{end}} = SOC_{\Delta v,\text{map}}\left(\frac{CCV_{\text{end}} - OCV_{\text{map}}(100\%)}{K_{T,\text{map}}(T_{\text{end}}) \times SOHR}, C_{\text{rate,end}}\right) \quad \dots (5)$$

$$SOC_{\text{start}} = SOC_{v,\text{map}}(OCV_{\text{start}})$$

In [Math 5], the initial rated capacity $Q_{\text{max,ini}}$ is a rated capacity of the storage battery 101 in the undeteriorated state. Moreover, $CCV_{\text{end}}$ is the CCV at the end of charging, and OCV (SOC=100%) is the OCV in the case where the SOC is 100%. Note that, in the example of the SOC-OCV characteristic C41 shown in Fig. 6, almost no change is found in the OCV in a range in which the SOC is 70 to 100%. Specifically, when the SOC is 70% or more at the end of charging, OCV (SOC=100%) can be considered as the "OCV at the end of charging. Accordingly, "$CCV_{\text{end}}$-OCV (SOC=100%)" is a value corresponding to the charging overvoltage $\Delta V$ (see Fig. 9) at the end of charging. Note that the charging overvoltage $\Delta V$ shown in Fig. 9 is a value in the undeteriorated state, while the "$CCV_{\text{end}}$-OCV (SOC=100%)" is generally a value in the deteriorated state. Accordingly, this value in the deteriorated state is divided by "SOHR/100", and the result of this division is an estimated value of the charging overvoltage $\Delta V$ in the undeteriorated state.

According to Fig. 9, the SOC is a function of the charging overvoltage $\Delta V$ and the charge rate [CA]. The map MP10 stored in the map storage 116 (see Fig. 8) is a map defining relationships among the charging overvoltage $\Delta V$, various charge rates $C_{rate}$, and the SOC. A state-of-charge estimated value $SOC_{\Delta v,map}$ is an estimated value of the SOC obtained based on the charging overvoltage $\Delta V$, the charge rate $C_{rate}$, and the map MP10. Moreover, in [Math 5], a state-of-charge estimated value $SOC_{v,map}$ is an estimated value of the SOC obtained based on the OCV and the map MP4. Accordingly, the $SOC_{v,map}$ ($OCV_{start}$) is an estimated value of the SOC at the start of charging.

As described above, the estimated capacity deterioration rate $SOHQ_B$ obtained based on [Math 5] is a value with high validity in the case where the OCV before the charging belongs to a region in which the change amount of the OCV is high and the voltage value V immediately before the completion of charging is sufficiently high. As a method of determining whether the validity of the estimated capacity deterioration rate $SOHQ_B$ is high or not, for example, the determination can be made based on whether the following two conditions are satisfied or not: "the voltage value V immediately before the completion of charging is equal to or higher than a predetermined threshold voltage Vth1 (first threshold voltage, for example, 3.56 V)" and "the OCV (or the voltage value V) immediately before the start of charging is equal to or lower than a predetermined threshold voltage Vth2 (second threshold voltage, for example, 3.15 V)".

The second capacity deterioration estimator 154 outputs the estimated capacity deterioration rate $SOHQ_B$, provided that these two conditions are satisfied, and does not output the estimated capacity deterioration rate $SOHQ_B$ when at least one of the conditions is not satisfied. Note that the indices and thresholds described above are examples, and the present invention is not limited to the combination of these indices and thresholds.

The correction amount calculator 156 calculates a correction amount X based on [Math 6] described below when the second capacity deterioration estimator 154 calculates the estimated capacity deterioration rate $SOHQ_B$.

[Math 6]

$$X = SOHQ_B - SOHQ_A \qquad \dots (6)$$

Moreover, the corrector 152 calculates an estimated capacity deterioration rate $SOHQ_C$ (third estimated capacity deterioration rate) based on [Math 7] described below. The capacity deterioration estimation device 150 outputs the estimated capacity deterioration rate $SOHQ_C$ as the estimated value of the capacity deterioration rate SOHQ. The correction amount calculator 156 updates the correction amount X when the second capacity deterioration estimator 154 outputs the estimated capacity deterioration rate $SOHQ_B$ next time. Until then, the corrector 152 continues to apply the lastly-calculated correction amount X.

[Math 7]

$$SOHQ_C = SOHQ_A + X \qquad \dots (7)$$

Since a situation where the storage battery 101 is discharged to a point where the SOC reaches almost 0% does not generally frequently occur particularly in an electric vehicle and the like, an interval at which the estimated capacity deterioration rate $SOHQ_B$ is calculated tends to be long. According to the present embodiment, since the estimated capacity deterioration rate $SOHQ_C$ can be calculated based on the correction amount X also when the period in which the estimated capacity deterioration rate $SOHQ_B$ is not calculated is relatively long as described above, the accuracy of the estimated capacity deterioration rate $SOHQ_C$ can be improved.

[Third Embodiment]

Next, a capacity deterioration rate estimation system of a third embodiment is explained. The third embodiment is an embodiment in which the capacity deterioration estimation error caused by the errors in the various maps, the error in the charging data, and the like in the first and second embodiments is attempted to be further reduced. To this end, the highly-accurate capacity deterioration estimated value obtained when the above-mentioned second measurement condition is incidentally met (when the charging is started in a region where the open circuit voltage change is large near the SOC of 0% and is completed near the SOC of 100%) is used to perform gain correction of the next capacity deterioration estimated value and beyond. A configuration of the capacity deterioration rate estimation system in the third embodiment is the same as the capacity deterioration rate estimation system 2 (see Fig. 8) in the second embodiment except for the points described below.

The correction amount calculator 156 according to the present embodiment calculates a correction amount Y based on [Math 8] described below when the above-mentioned second measurement condition is met and the second capacity deterioration estimator 154 calculates the estimated capacity deterioration rate $SOHQ_B$.

[Math 8]

$$Y = \frac{SOHQ_B}{SOHQ_A} \qquad \dots (8)$$

Moreover, the corrector 152 calculates an estimated capacity deterioration rate $SOHQ_D$ (fourth estimated capacity deterioration rate) based on [Math 9] described below. The capacity deterioration estimation device 150 outputs this estimated capacity deterioration rate $SOHQ_D$ as the estimated value of the capacity deterioration rate SOHQ. The correction amount calculator 156 updates the correction amount Y when the second capacity deterioration estimator 154 outputs the estimated capacity deterioration rate $SOHQ_B$ next time. Until then, the corrector 152 continues to apply the lastly-calculated correction amount Y.

[Math 9]

$$SOHQ_D = SOHQ_A \times Y \qquad \dots (9)$$

The estimated capacity deterioration rate $SOHQ_D$ can be calculated based on the correction amount Y also in the present embodiment. Accordingly, the accuracy of the estimated capacity deterioration rate $SOHQ_D$ can be improved also when the period in which the estimated capacity deterioration rate $SOHQ_B$ is not calculated is relatively long.

[Fourth Embodiment]

Next, a capacity deterioration rate estimation system in a fourth embodiment is explained. The fourth embodiment is an embodiment in which the capacity deterioration estimation error caused by an error in the implemented map MP1 in the first and second embodiments is reduced. To this end, the map MP1 is corrected by using the highly-accurate capacity deterioration estimation value obtained when the above-mentioned second measurement condition is incidentally met. A configuration of the capacity deterioration rate estimation system in the fourth embodiment is the same as the capacity deterioration rate estimation system 2 (see Fig. 8) in the second embodiment except for the points described below.

An example of a correction method of the map MP1 stored in the map storage 116 according to the present embodiment is explained. When the above-mentioned second measurement condition is met, the corrector 152 adds the correction amount X to all table values of SOHQ corresponding to a SOHR region above the current SOHR in the map MP1.

Specifically, when the second measurement condition is satisfied, the corrector 152 updates the table values of the map MP1. The estimated capacity deterioration rate $SOHQ_A$ after the update of the map MP1 is referred to as the estimated capacity deterioration rate $SOHQ_E$ (fifth estimated capacity deterioration rate) in some cases. Since the map MP1 itself is corrected in the present embodiment as described above, if the correction amount X is added to the estimated capacity deterioration rate $SOHQ_E$ in the corrector 152, correction is performed twice. Accordingly, in the present embodiment, the estimated capacity deterioration rate $SOHQ_E$ is not corrected in the corrector 152. The fifth capacity deterioration rate $SOHQ_E$ calculated by using the updated map MP1 can be thereby calculated. Note that the correction method of the map MP1 explained above is merely an example, and the present invention is not limited to the above-mentioned method.

In the present embodiment, the estimated capacity deterioration rate $SOHQ_E$ can be calculated based on the updated map MP1. Accordingly, the accuracy of the estimated capacity deterioration rate $SOHQ_E$ can be improved also when the period in which the estimated capacity deterioration rate $SOHQ_B$ is not calculated is relatively long.

[Effects of Embodiments]

As described above, according to the above-mentioned embodiments, the capacity deterioration estimation devices 110 and 150 include: the data receiver 112 configured to receive the measurement results of the current value I and the voltage value V of the storage battery 101 from the measuring part 102 configured to measure the current value I and the voltage value V; and the first capacity deterioration estimator 114, and the first capacity deterioration estimator 114 has the function of reading, from the table storage (116), the first table (MP1) storing the relationship between the resistance deterioration rate SOHR of the storage battery 101 and the estimated capacity deterioration rate ($SOHQ_{map}$ (SOHR)) being the estimated value of the capacity deterioration rate SOHQ, the second table (MP2) storing the relationship between the state of charge SOC of the storage battery 101 and the reference resistance value ($R_{chg,ref,map}$) being the resistance value of the storage battery 101 in the undeteriorated state at the predetermined temperature, the third table (MP3) storing the relationship between the temperature of the storage battery 101 and the temperature conversion coefficient ($K_{T,map}$ (T)) being a ratio with respect to the reference resistance value ($R_{chg,ref,map}$), and the fourth table (MP4) storing the relationship between the state of charge SOC and the terminal open voltage (OCV) of the storage battery 101, and the function of calculating the first estimated capacity deterioration rate ($SOHQ_A$) based on the first relational expression (Math 1) defining the relationships among the reference resistance value ($R_{chg,ref,map}$), the resistance deterioration rate SOHR, and the start-of-charging state of charge $OSC_{start}$ being the state of charge SOC at the start of charging, the second relational expression (Math 2) defining the relationships among the reference resistance value ($R_{chg,ref,map}$), the resistance deterioration rate SOHR, and the end-of-charging state of charge $SOC_{end}$ being the state of charge SOC at the end of charging, the third relational expression (Math 3) defining the relationships among the start-of-charging state of charge $OSC_{start}$, the end-of-charging state of charge $SOC_{end}$, the first estimated capacity deterioration rate ($SOHQ_A$), and the charged electric amount being an electric amount from the start of charging to the end of charging, and the fourth relational expression (Math 4) defining the relationship between the resistance deterioration rate SOHR and the first estimated capacity deterioration rate ($SOHQ_A$). The first estimated capacity deterioration rate ($SOHQ_A$) can be thereby calculated, and the capacity deterioration of the storage battery can be thus appropriately estimated.

Moreover, it is further preferable that the second table (MP2) is the table storing the relationships among the state of charge SOC, the reference resistance value ($R_{chg,ref,map}$), and the charge rate $C_{rate}$ to the storage battery 101, the first relational expression (Math 1) is the expression defining the relationships among the start-of-charging state of charge $OSC_{start}$, the reference resistance value ($R_{chg,ref,map}$), the resistance deterioration rate SOHR, and the start-of-charging charge rate ($C_{rate,start}$) being the charge rate $C_{rate}$ at the start of charging, and the second relational expression (Math 2) is the expression defining the relationships among the end-of-charging state of charge $SOC_{end}$, the reference resistance value ($R_{chg,ref,map}$), the resistance deterioration rate SOHR, and the end-of-charging charge rate ($C_{rate,end}$) being the charge rate $C_{rate}$ at the end of charging. The capacity deterioration can be thereby appropriately estimated also in the storage battery 101 in which the reference resistance value ($R_{chg,ref,map}$) changes depending on the charge rate $C_{rate}$.

Furthermore, it is further preferable that the first capacity deterioration estimator 114 calculates the first estimated capacity deterioration rate ($SOHQ_A$), provided that the predetermined first measurement condition is satisfied. Moreover, it is further preferable that the first measurement condition is such a condition that the voltage of the storage battery 101 immediately before the completion of charging is equal to or higher than the predetermined first threshold voltage (Vth1). The capacity degradation of the storage battery 101 can be thereby appropriately estimated only when the storage battery 101 is in the state close to the full charge state, by appropriately setting the first threshold voltage (Vth1).

Furthermore, it is further preferable that the capacity deterioration estimation device 150 further includes the second capacity deterioration estimator 154 configured to calculate the second estimated capacity deterioration rate ($SOHQ_B$) based on the voltage value V when the predetermined second measurement condition is satisfied, the correction amount calculator 156 configured to calculate the correction amounts X and Y based on the first and second estimated capacity deterioration rates ($SOHQ_A$ and $SOHQ_B$), and the corrector 152 configured to calculate the third estimated capacity deterioration rate ($SOHQ_C$) based on the first estimated capacity deterioration rate ($SOHQ_A$) and the correction amounts X and Y. The third estimated capacity deterioration rate ($SOHQ_C$) that is more appropriate can be thereby obtained based on the second estimated capacity deterioration rate ($SOHQ_B$).

Moreover, it is further preferable that the capacity deterioration estimation device 150 further includes the second capacity deterioration estimator 154 configured to calculate the second estimated capacity deterioration rate ($SOHQ_B$) based on the voltage value V when the predetermined second measurement condition is satisfied and the corrector 152 configured to correct the first table (MP1) based on the first and second estimated capacity deterioration rates ($SOHQ_A$ and $SOHQ_B$). The first estimated capacity deterioration rate ($SOHQ_A$) that is more appropriate can be thereby obtained based on the second estimated capacity deterioration rate ($SOHQ_B$).

Furthermore, it is further preferable that the second capacity deterioration estimator 154 calculates the second estimated capacity deterioration rate ($SOHQ_B$) based on the start-of-charging state of charge $SOC_{start}$, the end-of-charging state of charge $SOC_{end}$, and the charged electric amount. The second estimated capacity deterioration rate ($SOHQ_B$) can be thereby calculated based on the start-of-charging state of charge $SOC_{start}$, the end-of-charging state of charge $SOC_{end}$, and the charged electric amount.

Moreover, it is further preferable that the second measurement condition is such a condition that the voltage value V immediately before the completion of charging of the storage battery 101 is equal to or higher than the first threshold voltage (Vth1) and the voltage value V immediately before the start of charging is equal to or lower than the predetermined second threshold voltage (Vth2). The second estimated capacity deterioration rate ($SOHQ_B$) can be thereby calculated when the change range of the voltage value V is appropriate.

Moreover, it is further preferable that the capacity deterioration estimation device 150 further includes the second capacity deterioration estimator 154 configured to calculate the second estimated capacity deterioration rate ($SOHQ_B$) based on the voltage value V when the predetermined measurement condition is satisfied, the correction amount calculator 156 configured to calculate the correction amounts X and Y based on the first estimated capacity deterioration rate ($SOHQ_A$) and the second estimated capacity deterioration rate ($SOHQ_B$), and the corrector 152 configured to calculate the third to fifth estimated capacity deterioration rates ($SOHQ_C$, $SOHQ_D$, and $SOHQ_E$) based on the first estimated capacity deterioration rate ($SOHQ_A$) and the correction amounts X and Y. The final estimated capacity deterioration rate, for example, the third to fifth estimated capacity deterioration rates ($SOHQ_C$, $SOHQ_D$, and $SOHQ_E$) can be thereby calculated by using the second estimated capacity deterioration rate ($SOHQ_B$) calculated based on the voltage value in addition, and the capacity deterioration of the storage battery can be thus more appropriately estimated.

[Modified Examples]

The present invention is not limited to the embodiments described above, and various changes can be made. The above-mentioned embodiments are given as examples to explain the present invention in an easily understandable manner, and the present invention is not necessarily limited to embodiments including all of the configurations explained above. Moreover, at least part of the configurations in one of the embodiments can be replaced by a configuration in another embodiment, and a configuration in one of the embodiments can be added to the configurations in another embodiment. Furthermore, at least part of the configurations in each embodiment may be omitted, or substituted by another configuration, or another configuration may be added thereto. Moreover, control lines and information lines shown in the drawings are lines assumed to be necessary for the sake of explanation, and not all of the control lines and the information lines required for a product are necessarily shown. In actual, almost all of the configurations are assumed to be connected to one another. Modifications that can be made on the above-mentioned embodiments include, for example, the following modifications.

(1) In the above-mentioned embodiments, application to the storage battery for a moving body is explained. However, the field of application of the present invention is not limited to this, and the present invention can be applied to a storage battery of stationary equipment.

(2) In each of the embodiments described above, the measuring part 102 measures the battery temperature T of the storage battery 101. However, in the case where the battery temperature T is substantially constant, the measurement of the battery temperature T may be omitted.

(3) Since the hardware of the capacity deterioration estimation devices 110 and 150 in the above-mentioned embodiments can be implemented by a general computer, a program or the like that executes the various processes described above may be stored in a storage medium or distributed via a transmission route.

(4) Although the above-mentioned processes are explained as software processes using the program in the above-mentioned embodiments, part or all of the processes may be replaced by hardware processes using an ASIC (application specific integrated circuit), an FPGA (field programmable gate array), or the like.

(5) The various processes executed in the above-mentioned embodiments may be execute by a server computer via a not-shown network, and the various pieces data stored in the above-mentioned embodiments may also be stored in the server computer.

[Additional Description]

Since [Math 5] is described as [Math 5A] below in JP2022-135627A that is the basic application of the present application, [Math 5A] is additionally described.

[Math 5A]

$$SOHQ_B = \frac{\int_{t_{\text{start}}}^{t_{\text{end}}} I \cdot dt}{Q_{\text{max,ini}}} \times \frac{1}{SOC_{\text{end}} - SOC_{\text{start}}}$$

$$SOC_{\text{end}} = SOC_{\Delta v,\text{map}} \left( \frac{CCV_{\text{end}} - OCV_{\text{map}}(100\%)}{SOHR}, C_{\text{rate,end}} \right) \quad \cdots \quad (5A)$$

$$SOC_{\text{start}} = SOC_{v,\text{map}}(OCV_{\text{start}})$$

**Reference Signs List**

101 storage battery
102 measuring part
110, 150 capacity deterioration estimation device (computer)

112 data receiver
114 first capacity deterioration estimator
116 map storage (table storage)
152 corrector
154 second capacity deterioration estimator
156 correction amount calculator
I current value
V voltage value
X, Y correction amount
MP1 map (first table)
MP2 map (second table)
MP3 map (third table)
MP4 map (fourth table)
OCV open circuit voltage (terminal open voltage)
SOC state of charge
Vth1 threshold voltage (first threshold voltage)
Vth2 threshold voltage (second threshold voltage)
SOHQ capacity deterioration rate
SOHR resistance deterioration rate
$C_{rate}$ charge rate
$SOHQ_A$ estimated capacity deterioration rate (first estimated capacity deterioration rate)
$SOHQ_B$ estimated capacity deterioration rate (second estimated capacity deterioration rate)
$SOHQ_C$ estimated capacity deterioration rate (third estimated capacity deterioration rate)
$SOHQ_D$ estimated capacity deterioration rate (fourth estimated capacity deterioration rate)
$SOHQ_E$ estimated capacity deterioration rate (fifth estimated capacity deterioration rate)
$SOC_{end}$ end-of-charging state of charge
$SOC_{start}$ start-of-charging state of charge

## Claims

1. A capacity deterioration estimation device comprising:

a data receiver configured to receive measurement results of a current value and a voltage value of a storage battery from a measuring part configured to measure the current value, the voltage value, and a temperature of the storage battery; and
a first capacity deterioration estimator, wherein
the first capacity deterioration estimator has

a function of reading, from a table storage, a first table storing a relationship between a resistance deterioration rate of the storage battery and an estimated capacity deterioration rate being an estimated value of a capacity deterioration rate, a second table storing a relationship between a state of charge of the storage battery and a reference resistance value being a resistance value of the storage battery in an undeteriorated state at a predetermined temperature, a third table storing a relationship between the temperature of the storage battery and a temperature conversion coefficient being a ratio with respect to the reference resistance value, and a fourth table storing a relationship between the state of charge and a terminal open voltage of the storage battery, and
a function of calculating a first estimated capacity deterioration rate based on a first relational expression defining relationships among the reference resistance value, the resistance deterioration rate, and a start-of-charging state of charge being the state of charge at start of charging, a second relational expression defining relationships among the reference resistance value, the resistance deterioration rate, and an end-of-charging state of charge being the state of charge at end of charging, a third relational expression defining relationships among the start-of-charging state of charge, the end-of-charging state of charge, the first estimated capacity deterioration rate, and a charged electric amount being an electric amount from the start of charging to the end of charging, and a fourth relational expression defining a relationship between the resistance deterioration rate and the first estimated capacity deterioration rate.

2. The capacity deterioration estimation device according to claim 1, wherein

the second table is a table storing relationships among the state of charge, the reference resistance value, and a charge rate to the storage battery,

the first relational expression is an expression defining relationships among the start-of-charging state of charge, the reference resistance value, the resistance deterioration rate, and a start-of-charging charge rate being the charge rate at the start of charging, and

the second relational expression is an expression defining relationships among the end-of-charging state of charge, the reference resistance value, the resistance deterioration rate, and an end-of-charging charge rate being the charge rate at the end of charging.

3. The capacity deterioration estimation device according to claim 1, wherein
the first capacity deterioration estimator calculates the first estimated capacity deterioration rate, provided that a predetermined first measurement condition is satisfied.

4. The capacity deterioration estimation device according to claim 3, wherein
the first measurement condition is such a condition that a voltage of the storage battery immediately before completion of charging is equal to or higher than a predetermined first threshold voltage.

5. The capacity deterioration estimation device according to claim 1, further comprising:

a second capacity deterioration estimator configured to calculate a second estimated capacity deterioration rate based on the voltage value when a predetermined second measurement condition is satisfied;
a correction amount calculator configured to calculate a correction amount based on the first and second estimated capacity deterioration rates; and
a corrector configured to calculate a third estimated capacity deterioration rate based on the first estimated capacity deterioration rate and the correction amount.

6. The capacity deterioration estimation device according to claim 1, further comprising:

a second capacity deterioration estimator configured to calculate a second estimated capacity deterioration rate based on the voltage value when a predetermined second measurement condition is satisfied; and
a corrector configured to correct the first table based on the first and second estimated capacity deterioration rates.

7. The capacity deterioration estimation device according to claim 5 or 6, wherein
the second capacity deterioration estimator calculates the second estimated capacity deterioration rate based on the start-of-charging state of charge, the end-of-charging state of charge, and the charged electric amount.

8. The capacity deterioration estimation device according to claim 7, wherein
the second measurement condition is such a condition that the voltage value immediately before the completion of charging of the storage battery is equal to or higher than a first threshold voltage and the voltage value immediately before the start of charging is equal to or lower than a predetermined second threshold voltage.

# FIG. 1

# FIG. 2

## FIG. 3

## FIG. 4

# FIG. 5

MP3

# FIG. 6

MP4

C41

# FIG. 7

```
                    ┌─────────────────────────────┐
                    │            Start            │
                    └─────────────────────────────┘
                                   │
                                   ▼
S01 ┌─────────────────────────────────────────────────┐
    │              OBTAIN CHARGING DATA                │
    └─────────────────────────────────────────────────┘
                                   │
                                   ▼
S02 ┌─────────────────────────────────────────────────┐
    │    READ CURRENT, VOLTAGE, AND BATTERY            │
    │    TEMPERATURE AT END OF CHARGING                │
    │          FROM CHARGING DATA                      │
    └─────────────────────────────────────────────────┘
                                   │
                                   ▼
S03              ◇─────────────────────────────◇        No
                 FIRST MEASUREMENT             ─────────────┐
                 CONDITION IS SATISFIED?                    │
                 ◇─────────────────────────────◇            │
                                   │ Yes                    │
                                   ▼                        │
S04 ┌─────────────────────────────────────────────────┐    │
    │         READ MP1, MP2, MP3, AND MP4              │    │
    │              FROM MAP STORAGE                    │    │
    └─────────────────────────────────────────────────┘    │
                                   │                        │
                                   ▼                        │
S05 ┌─────────────────────────────────────────────────┐    │
    │        READ CURRENT, VOLTAGE, AND                │    │
    │    BATTERY TEMPERATURE AT START OF               │    │
    │       CHARGING FROM CHARGING DATA                │    │
    └─────────────────────────────────────────────────┘    │
                                   │                        │
                                   ▼                        │
S06 ┌─────────────────────────────────────────────────┐    │
    │    SOLVE SIMULTANEOUS EQUATIONS OF               │    │
    │    [MATH 1] TO [MATH 4] TOCALCULATE              │    │
    │    ESTIMATED VALUE OF EACH OF                    │    │
    │    START-OF-CHARGING STATE OF CHARGE,            │    │
    │    END-OF-CHARGING STATE OF CHARGE,              │    │
    │    RESISTANCE DETERIORATION RATE,                │    │
    │    AND CAPACITY DETERIORATION RATE               │    │
    └─────────────────────────────────────────────────┘    │
                                   │                        │
                                   ▼                        │
S07 ┌─────────────────────────────────────────────────┐    │
    │         OUTPUT ESTIMATED VALUE OF                │    │
    │        CAPACITY DETERIORATION RATE               │    │
    └─────────────────────────────────────────────────┘    │
                                   │                        │
                                   ▼                        │
                    ┌─────────────────────────────┐         │
                    │             End             │◄────────┘
                    └─────────────────────────────┘
```

# FIG. 8

# FIG. 9

## INTERNATIONAL SEARCH REPORT

| International application No. |
|---|
| **PCT/JP2023/023085** |

| A. | CLASSIFICATION OF SUBJECT MATTER |
|---|---|

*G01R 31/392*(2019.01)i; *G01R 31/382*(2019.01)i; *G01R 31/385*(2019.01)i; *G01R 31/389*(2019.01)i; *H01M 10/48*(2006.01)i; *H02J 7/00*(2006.01)i
FI:    G01R31/392; G01R31/382; G01R31/385; G01R31/389; H01M10/48 P; H01M10/48 301; H02J7/00 Q

According to International Patent Classification (IPC) or to both national classification and IPC

| B. | FIELDS SEARCHED |
|---|---|

Minimum documentation searched (classification system followed by classification symbols)

G01R31/36-31/396; H01M10/42-10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2018/179852 A1 (HITACHI AUTOMOTIVE SYSTEMS LTD) 04 October 2018 (2018-10-04)<br>    entire text | 1-8 |
| A | JP 2019-103157 A (DENSO CORP) 24 June 2019 (2019-06-24)<br>    paragraphs [0065]-[0066], fig. 18 | 1-8 |
| A | WO 2020/218184 A1 (GS YUASA INTERNATIONAL LTD.) 29 October 2020 (2020-10-29)<br>    paragraphs [0120]-[0129], fig. 23-25 | 1-8 |
| A | WO 2021/049134 A1 (HITACHI LTD) 18 March 2021 (2021-03-18)<br>    paragraphs [0036]-[0048], fig. 7B | 1-8 |
| A | WO 2022/024994 A1 (HITACHI CONSTRUCTION MACHINERY CO., LTD.) 03 February 2022 (2022-02-03)<br>    entire text | 1-8 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **02 August 2023** | **15 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

**INTERNATIONAL SEARCH REPORT**
Information on patent family members

International application No.

**PCT/JP2023/023085**

| Patent document cited in search report | | | Publication date (day/month/year) | Patent family member(s) | | | Publication date (day/month/year) |
|---|---|---|---|---|---|---|---|
| WO | 2018/179852 | A1 | 04 October 2018 | EP | 3605123 | A1 | |
| | | | | CN | 110446938 | A | |
| | | | | JP | 2018-169284 | A | |
| JP | 2019-103157 | A | 24 June 2019 | US | 2019/0165586 | A1 | |
| | | | | paragraphs [0098]-[0099], fig. 18 | | | |
| WO | 2020/218184 | A1 | 29 October 2020 | US | 2022/0179010 | A1 | |
| | | | | paragraphs [0160]-[0169], fig. 23-25 | | | |
| | | | | DE | 112020002141 | T5 | |
| | | | | CN | 113826260 | A | |
| | | | | JP | 2020-180935 | A | |
| WO | 2021/049134 | A1 | 18 March 2021 | JP | 2021-44145 | A | |
| WO | 2022/024994 | A1 | 03 February 2022 | EP | 4191743 | A1 | |
| | | | | KR | 10-2023-0028789 | A | |
| | | | | CN | 116235339 | A | |
| | | | | JP | 2022-25274 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019021417 A
- JP 2020187050 A
- JP 2022135627 A